**Europäisches Patentamt**

**European Patent Office**

**Office européen des brevets**

(19)

(11) **EP 1 213 813 A2**

(12) **EUROPÄISCHE PATENTANMELDUNG**

(43) Veröffentlichungstag:
    **12.06.2002 Patentblatt 2002/24**

(51) Int Cl.⁷: **H02H 3/44**, H02H 3/08

(21) Anmeldenummer: **02005886.3**

(22) Anmeldetag: **18.08.1999**

(84) Benannte Vertragsstaaten:
    **AT BE CH CY DE DK ES FI FR GB GR IE IT LI LU MC NL PT SE**

(30) Priorität: **31.08.1998 DE 19839617**

(62) Dokumentnummer(n) der früheren Anmeldung(en) nach Art. 76 EPÜ:
    **99953531.3 / 1 110 286**

(71) Anmelder: **SIEMENS AKTIENGESELLSCHAFT 80333 München (DE)**

(72) Erfinder:
    • **Griepentrog, Gerd, Dr.**
      **91468 Gutenstetten (DE)**
    • **Maier, Reinhard**
      **91074 Herzogenaurach (DE)**
    • **Mitlehner, Heinz**
      **91080 Uttenreuth (DE)**
    • **Zerbian, Erich**
      **92269 Fensterbach (DE)**

Bemerkungen:
    Diese Anmeldung ist am 14 - 03 - 2002 als Teilanmeldung zu der unter INID-Kode 62 erwähnten Anmeldung eingereicht worden.

(54) **Schutzeinrichtung für Niederspannungsnetze**

(57) Derartige Schutzeinrichtungen haben üblicherweise eine Messeinrichtung und eine nachgeschaltete Auswerteeinrichtung. Gemäß der Erfindung ist die Auswerteeinrichtung eine Einheit zur Kurzschlussfrüherkennung (20, 40), von der ein vorzugsweise auf SiC-Basis hergestellter Halbleiterschalter (50) angesteuert wird. Vorzugsweise arbeitet die Einheit zur Kurzschlussfrüherkennung (20, 40) mit vorgebbaren Schwellwerten für das Produkt aus Strom i und Stromsteilheit di/dt oder auf der Basis von toleranten Ortskurven. Bei letzteren sind in einer Ortskurvendarstellung von Strom (i) und Stromsteilheit (di/dt) in den Ortskurven unterschiedliche Leistungsfaktoren (0,1 < cosφ < 0,9) verwendet. Der Halbleiterschalter (50) enthält vorzugsweise zwei antiserielle Schaltelemente auf SiC-Basis.

**Beschreibung**

Die Erfindung bezieht sich auf eine Schutzeinrichtung für Niederspannungsnetze mit einer Messeinrichtung und einer nachgeschalteten Auswerteeinrichtung.

Durch Kurzschlüsse werden elektrische Anlagen elektrodynamisch und thermisch beansprucht. Diese Beanspruchung wird sowohl durch die Zeit, die bis zur Erkennung des Kurzschlusses vergeht (sog. Kurzschlusserkennungszeit) als auch von der zur Abschaltung des Kurzschlusses notwendigen Zeit (sog. Abschaltzeit) beeinflusst.

Für die Erkennung von Überlastzuständen werden bekanntermaßen elektronische bzw. μP-gesteuerte Auswerteschaltungen eingesetzt, die aber im Wesentlichen die Bimetallfunktion nachbilden. Bei einfachen Geräten werden magnetische Auslösespulen und Bimetalle verwendet, die keinen optimalen Schutz bieten. Die Abschaltung des Kurzschlusses erfolgt fast ausnahmslos durch mechanische Schalter, wobei die Kontakttrennung üblicherweise erst nach einer gewissen Reaktionszeit beginnt und durch den sich ausbildenden Lichtbogen eine der Netzspannung entgegenwirkende Spannung entsteht. Diese Bogenspannung begrenzt den Kurzschlussstrom und bringt ihn schließlich zum Erlöschen. Schalter auf der Basis herkömmlicher Halbleiter finden wegen der hohen Durchgangsverluste im Nennbetrieb nur in Ausnahmefällen Verwendung.

Aus der EP 0 838 887 A2 ist ein elektrisches Energieverteilungssystem mit automatisch arbeitenden Schutzeinrichtungen bekannt, bei der eine Einheit zur Kurzschlussfrüherkennung vorhanden ist, die den Augenblickswert des Stromes einerseits und dessen zeitliche Änderung andererseits berücksichtigt. Dabei werden in diesem Fall von der Einheit zur Kurzschlussfrüherkennung übliche Leistungsschalter angesteuert.

Aufgabe der Erfindung ist es, eine Schutzeinrichtung zu schaffen, die in Niederspannungsnetzen einen hinreichenden Schutz von Schaltgeräten gegen Überlastung und Kurzschluss realisiert, indem anomale Betriebszustände sehr schnell erkannt werden.

Die Aufgabe ist erfindungsgemäß bei einer Schutzeinrichtung der eingangs genannten Art durch die Merkmale des Patentanspruches 1 gelöst. Vorteilhafte Weiterbildungen sind in den abhängigen Ansprüchen angegeben.

Bei der Erfindung ist die Auswerteeinrichtung eine Einheit zur Kurzschlussfrüherkennung, von der ein Halbleiterschalter angesteuert wird, wobei hierdurch der fehlerhafte Abzweig vom Netz getrennt wird. Vorzugsweise ist der Halbleiterschalter auf Siliciumcarbid (SiC)-Basis hergestellt, wie es beispielsweise bei einem elektronischen Abzweigschaltgerät gemäß der DE 196 12 216 A1 erwähnt wird. Ein solcher Schalter ist vorzugsweise als sog. JFET realisiert.

Bei der Erfindung ergibt die Kombination einer an sich bekannten Einheit zur Kurzschlussfrüherkennung mit bekannten Halbleiterschaltern unerwartet günstige Kurzschlussausschalteigenschaften. Die Einheit zur Kurzschlussfrüherkennung arbeitet auf der Basis des Produktes von Strom und Stromsteilheit.

Mit der Erfindung werden im Wesentlichen vom Stand der Technik bereits vorgeschlagene Mittel in neuartiger Weise kombiniert. Auch Schalter auf SiC-Basis sind aus neueren Veröffentlichungen bekannt. Die Kurzschlussfrüherkennung mit Hilfe von Strom- und Stromsteilheit gehört zum gängigen Stand der Technik ein nach dem Prinzip der sogenannten toleranten Ortskurven arbeitendes Verfahren zur Kurzschlussfrüherkennung (TOK-Verfahren) in der älteren, nichtvorveröffentlichten deutschen Patentanmeldung 197 29 599.1 vorgeschlagen wird.

Solche nach dem TOK-Verfahren arbeitende Einheiten können analog, digital oder hybrid aufgebaut sein. Wesentlich ist in allen Fällen, dass die im Halbleiterschalter umzusetzende Schaltarbeit durch die schnelle Kurzschlusserkennung reduziert wird, was zu kleineren Halbleitervolumina und damit insbesondere kleineren Schaltern führt.

Bei der Erfindung ist vorteilhaft in allen Fällen, dass die im Halbleiterschalter umzusetzende Schaltarbeit durch die schnelle Kurzschlusserkennung reduziert wird, was zu kleineren Halbleitervolumina und damit insbesondere kleineren Schaltern führt.

Weitere Einzelheiten und Vorteile der Erfindung ergeben sich aus nachfolgender Figurenbeschreibung von Ausführungsbeispielen anhand der Zeichnung in Verbindung mit weiteren Patentansprüchen. Die einzige Figur zeigt eine Einrichtung zur Kurzschlussfrüherkennung mit Hilfe des Toleranten Ortskurven (TOK)-Verfahrens auf der Basis eines digital arbeitenden Mikroprozessors sowie nachfolgender Ansteuerung eines Halbleiterschalters auf SiC-Basis zur Trennung des fehlerbehafteten Netzes.

In der Figur sind jeweils Anordnungen zur Kurzschlusserkennung und Abschaltung mittels Halbleiter-Schalter anhand einer einphasigen Schaltung verdeutlicht. Die gleiche Schaltung kann auch mehrphasig aufgebaut sein.

In der Figur bedeutet N den Neutralleiter und L1 einen Phasenleiter. An die Leitungen ist ein Verbraucher 10 angeschlossen.

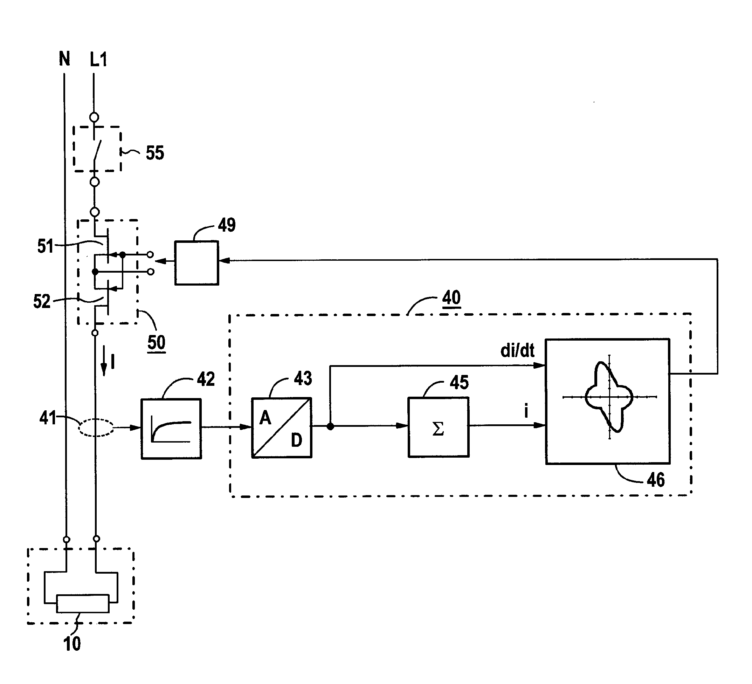

In der Figur ist im Phasenleiter L1 ein Stromwandler 11 vorhanden, der beispielsweise nach dem Prinzip des leiterplattenintegrierten Stromwandlers aufgebaut sein kann. Dabei kann der Stromwandler als sogenannter Mehrwicklungswandler realisiert sein, bei dem auf der Sekundärseite mehrere Wicklungen vorhanden sind, wobei das Stromsignal gemäß Figur 1 beispielsweise über einen Bürdenwiderstand abgenommen wird.

Vom Komparator 24 wird bei Überschreiten der Schwellwertkriterien ein Auslösesignal geliefert, das eine Einheit 49 zur Gateansteuerung eines sogenannten JFET 50 aktiviert. Mit dem JFET 50 kann der Kurzschluss ohne weitere Verzögerung abgeschaltet werden. Um Schalthandlungen in Wechselstromnetzen zu ermöglichen, besteht das JFET 50 aus zwei antiseriell geschalteten Halbleiterbauelementen 51 und 52, was vom Stand der Technik bekannt ist.

Halbleitermaterialien auf SiC-Basis weisen gegenüber herkömmlichen Halbleiter-Ventilen sehr geringe Durchlassverluste auf, da aufgrund der hohen Durchbruchfeldstärke das SiC sehr dünne Bauelemente gefertigt werden können. Somit bleibt der Durchgangswiderstand gering. Dies hat den Vorteil, dass nach der Erkennung des Kurzschlusses nahezu verzögerungsfrei abgeschaltet werden kann, was die thermische und elektrodynamische Beanspruchung der zu schützenden Anlage vermindert. Durch eine schnelle Kurzschlusserkennung wird die im Halbleiter umzusetzende Schaltarbeit reduziert, wodurch Halbleiter und Kühleinrichtungen kleiner als bisher dimensioniert werden können. Gleichermaßen wird in der Hauptstrombahn eine geringe Durchgangsverlustleistung im Nennbetrieb erreicht.

Neben dem abschaltenden Halbleiterschalter 50 auf SiC-Basis kann weiterhin ein Trennschalter 55 vorhanden sein, der nach Abschaltung des fehlerbehafteten Stromkreises eine sichtbare Trennstrecke mit galvanischer Trennung schafft.

In der Figur ist eine Anordnung zur Kurzschlussfrüherkennung mit dem TOK-Kriterium für ein JFET 50 auf SiC-Basis im Einzelnen dargestellt. Zur Realisierung kann auf übliche Schaltmittel zurückgegriffen werden. Entsprechende Anordnungen können rein analog, rein digital oder aber hybrid arbeiten, wobei sich letzteres anbietet.

In der Figur ist ein Sensor 41 zur Messung der Stromsteilheit di/dt, z.B. eine Rogowski-Spule, oder der Stromstärke i, ein A/D-Umsetzer 43 mit vorgeschaltetem Tiefpassfilter 42, eine Pegelanpassung 44 zur gleichzeitigen Einstellung der Nennstromstärke, eine Summiereinheit 45 zur Berechnung des Stromes i aus der Stromsteilheit di/dt bzw. alternativ eine Differenziereinheit zur Berechnung der Stromsteilheit di/dt aus der Stromstärke i sowie eine digital arbeitende Auswerteeinheit 46, welche die gemessenen Werte mit dem TOK-Kriterium vergleicht und bei Erkennung eines Kurzschlusses einen Auslöser 47 ansteuert, vorhanden.

In der Auswerteeinheit 46 ist in einem Diagramm auf der Abszisse $1:I_N$ und auf der Ordinate $1/(\omega \cdot I_N) \cdot \frac{di}{dt}$ aufgetragen. In dieser Ortskurve ist eine Einhüllende 3 dargestellt, die für einen vorgegebenen Schaltwinkelbereich einerseits und einen Leistungsfaktorbereich von $0,1 > \cos\varphi < 0,9$ alle Schaltzustände einschließt. Mit der Einhüllenden 3 werden also alle Ortskurven bei beliebigen Schaltwinkeln und bei den daraus für verschiedene Leistungsfaktoren zunächst ermittelten Einhüllenden in einer gemeinsamen Kurve berücksichtigt. Dies bedeutet, dass für den Fall, dass während des Betriebes einer Anlage ein durch die Augenblickswerte von Strom i und Stromsteilheit di/dt gebildeter Betriebspunkt außerhalb der gebildeten Einhüllenden 3 liegt, ein Kurzschluss vorliegt. Damit ist in den vorgegebenen Grenzen nunmehr eine Unabhängigkeit von Leistungsfaktor und Vorstrom realisiert, wobei das Entscheidungsmerkmal als sogenanntes TOK-Kriterium (tolerantes Ortskurvenkriterium) bezeichnet wird. Untersuchungen zu diesem Verfahren sind in der älteren deutschen Patentanmeldung 197 29 599.1 im Einzelnen ausgeführt.

Die beschriebene Anordnung kann zur schnellen Erkennung von Kurzschlüssen in Niederspannungsnetzen in Verbindung mit dem JFET 50 eingesetzt werden. Dafür ist dem JFET eine Einheit 49 zur Gate-Ansteuerung vorgeschaltet, die mit einem vorgegebenen Algorithmus arbeitet. Dem JFET 50 kann jeweils ein mechanischer Trenner 55 nachgeschaltet sein.

**Patentansprüche**

1. Schutzeinrichtung für Niederspannungsnetze mit einer Messeinrichtung und einer nachgeschalteten Auswerteeinrichtung, wobei die Auswerteeinrichtung eine die Augenblickswerte von Strom (i) und Stromsteilheit (di/dt) auswertende Einheit zur Kurzschlussfrüherkennung (20, 24) ist, die auf der Basis von toleranten Ortskurven (TOK-Verfahren) arbeitet und bei der in einer Ortskurvendarstellung von Strom (i) und Stromsteilheit (di/dt) unterschiedliche Leistungsfaktoren ($0,1 < \cos\varphi < 0,9$) berücksichtigende Ortskurven als Auslösekriterien für einen Kurzschluss verwendet sind, und wobei von der Einheit zur Kurzschlussfrüherkennung (40, 46) ein Halbleiterschalter (50) angesteuert wird.

2. Schutzeinrichtung nach Anspruch 1, **dadurch gekennzeichnet, dass** die nach dem TOK-Verfahren arbeitende Einheit zur Kurzschlussfrüherkennung (40, 46) digitale Schaltmittel aufweist.

3. Schutzeinrichtung nach Anspruch 1, **dadurch gekennzeichnet, dass** die nach dem TOK-Verfahren arbeitende Einheit (40) zur Kurzschlussfrüherkennung analoge Schaltmittel aufweist.

4. Schutzeinrichtung für Niederspannungsnetze nach einem der vorhergehenden Ansprüche, **dadurch gekennzeichnet, dass** der Halbleiterschalter (50) auf der Basis von Siliziumcarbid (SiC) hergestellt ist.

5. Schutzeinrichtung nach Anspruch 4, **dadurch gekennzeichnet, dass** der Halbleiterschalter (50) ein sogenanntes JFET ist.

6. Schutzeinrichtung nach einem der vorhergehenden Ansprüche, **dadurch gekennzeichnet, dass** als Halbleiterschalter zwei antiserielle Halbleiterbauelemente (51, 52) geschaltet sind.

7. Schutzeinrichtung nach einem der vorhergehenden Ansprüche, **dadurch gekennzeichnet, dass** dem Halbleiterschalter (50) ein mechanischer Trennschalter (55) zugeordnet ist.